# EUROPEAN PATENT APPLICATION

(11) **EP 1 274 124 A1**
(43) Date of publication of application: **08.01.2003**
(21) Application number: 01921834.6
(22) Date of filing: 13.04.2001
(51) Int. Cl.: H01L 21/68, H01L 21/66, H05B 3/06, H05B 3/10, H05B 3/16, H05B 3/18, H05B 3/20, H05B 3/68

(54) **CERAMIC SUBSTRATE**

(30) Priority: 13.04.2000 JP 2000112464; 01.05.2000 JP 2000132122
(71) Applicant: IBIDEN CO., LTD., Ogaki-shi Gifu-ken 503-0917 (JP)
(72) Inventor: HIRAMATSU, Yasuji c/o IBIDEN CO., LTD., Ibi-gun, Gifu 501-0695 (JP); ITO, Yasutaka c/o IBIDEN CO., LTD., Ibi-gun, Gifu 501-0695 (JP)
(74) Representative: Gillard, Marie-Louise
(86) International application number: JP0103197
(87) International publication number: WO01080307

(57) **Abstract**

An objective of the present invention is to provide a ceramic substrate which does not generate any crack by a shock when the ceramic substrate is fitted to a supporting case or taken off therefrom or any crack resulting from a thermal stress, a thermal shock and the like when the ceramic substrate is heated after the fixation thereof to the supporting case, and which is capable of being prevented from being rotated. The present invention is a ceramic substrate having a conductor layer formed inside thereof or on the surface thereof, wherein a notch is formed.

## Description

### Technical Field

The present invention relates to a ceramic substrate used mainly as a device for producing or examining a semiconductor, such as a hot plate (ceramic heater), an electrostatic chuck, or a wafer prober.

### Background Art

Hitherto, a heater, wafer prober and the like wherein a base material made of metal such as stainless steel or aluminum alloy is used has been used in semiconductor producing/examining devices and so on, examples of which include an etching device and a chemical vapor deposition device.

However, such a heater made of metal has the following problems.

First, the thickness of the heater plate must be made as thick as about 15 mm since the heater is made of metal. Because in a thin metal plate a bend, a strain and so on are generated on the basis of thermal expansion resulting from heating so that a silicon wafer put on the metal plate is damaged or inclined. However, if the thickness of the heater plate is made thick, a problem that the heater becomes heavy and bulky arises.

The temperature of a face for heating an object to be heated such as a silicon wafer (referred to as a heating face hereinafter) is controlled by changing the voltage or current amount applied to resistance heating elements. However, since the metal plate is thick, the temperature of the heater plate does not follow the change in the voltage or current amount promptly. Thus, a problem that the temperature is not easily controlled is caused as well.

Thus, JP Kokai Hei 4-324276 suggests a ceramic heater wherein aluminum nitride, which is a non-oxide ceramic having a high thermal conductivity and a high strength, is used as a substrate, resistance heating elements and a conductor-filled through holes comprising tungsten are made in this aluminum nitride, and nichrome wires as external terminals are brazed thereto.

Since the ceramic substrate whose mechanical strength is high even at high temperature is used in such a ceramic heater, the thickness of the ceramic substrate is made thin so that its heat capacity can be made small. As a result, the temperature of the ceramic substrate can be caused to follow a change in voltage or electric current amount promptly.

In ceramic heaters of this type, the temperature of their ceramic substrates is usually controlled in the manner of: setting up temperature-measuring elements on the surface of the ceramic substrate or inside the ceramic substrate; fitting this ceramic substrate into a supporting case made of a metal through a heat insulating member made of a resin; connecting wiring from the temperature-measuring elements or wiring from resistance heating elements to a control device, and applying voltage to the resistance heating elements on the basis of the temperature measured with the temperature-measuring elements.

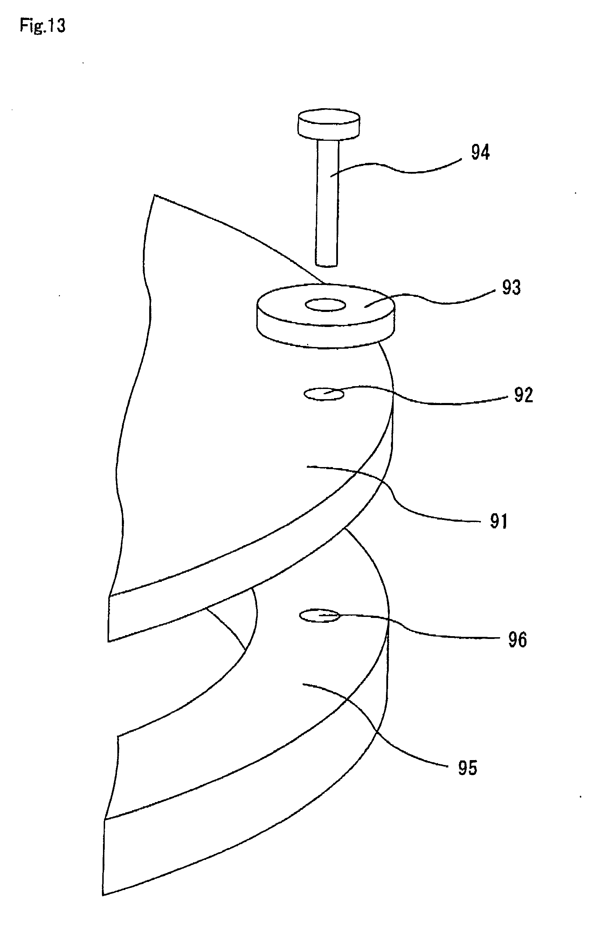

Fig. 13 is an exploded perspective view illustrating a state that a ceramic substrate of a ceramic heater of this type is fitted into a supporting case with a fixing member.

As illustrated in Fig. 13, through holes 92, into which fixing members such as bolts are fitted, are formed near the circumferential rim portion of a ceramic substrate 91, and the fixing members 94 are inserted into the through holes 92 through washers 93. By screwing the fixing members 94 into through holes 96 in a supporting case 95, the ceramic substrate 91 is fixed to the supporting case 95. A heat insulating member made of a resin and the like is usually interposed between the supporting case 95 and the ceramic substrate 91.

### Summary of the Invention

However, in case that the ceramic substrate 91 having these through holes 92 is used, the distance between the through holes 92 and the side face of the ceramic substrate 91 is short. Therefore, a problem that a crack is easily generated between the through holes 92 and the side face of the ceramic substrate 91 is caused: by a shock which is generated when the ceramic substrate 91 is fitted in or taken off; or by a thermal stress or a thermal shock which is generated in the ceramic substrate 91 at the time of the heating the ceramic substrate 91 and the like after the ceramic substrate 91 is fitted.

Also, when the ceramic substrate 91 is exchanged, the ceramic substrate 91 cannot be taken off from the supporting case even if the fixing members 94 are not completely pulled out. Thus, a problem that much time is required for fitting or taking off the ceramic substrate 91 arises.

Further, the ceramic substrate 91 has a disc shape so as to match the shape of a silicon wafer. In case that the through holes 92 are not formed in the ceramic substrate 91, the ceramic substrate 91 rotates easily because the ceramic substrate 91 is in the form of the disc. If the ceramic substrate 91 rotates, there arises a problem that wirings from temperature-measuring elements connected to the ceramic substrate 91 or from resistance heating elements are twisted and are detached.

In light of the above-mentioned problems, the present invention has been made. An objective thereof is to provide a ceramic substrate: which does not generate any crack even if a shock is caused when the ceramic substrate is fitted to a supporting case or taken off therefrom, or even if a stress or a thermal shock is caused at the time of heating the ceramic substrate after it is fitted into the supporting case; which is capable of being exchanged in a short time; and which can be prevented from rotating even if through holes are not formed in the present ceramic substrate.

The present invention is a ceramic substrate having a conductor layer formed inside thereof or on the surface thereof,
wherein a notch is formed.

According to the present invention, the notch functions as the through holes 92 (reference to Fig. 13) in the ceramic substrate 91 of the prior art. By inserting a fixing member into this notch, the ceramic substrate can be fixed into a supporting case. Moreover, the ceramic substrate has the notch; therefore, it does not happen: that a crack is generated by a shock when the ceramic substrate is fitted in or taken off as in the prior art; or that a crack is generated because of a stress or a thermal shock which acts on the ceramic substrate. By loosing the fixing member and then shifting the ceramic substrate, the ceramic substrate can be taken off from the supporting case without completely pulling out the fixing member from the ceramic substrate. Thus, the ceramic substrate can be fitted or taken off in a short time. Since the ceramic substrate in a disc form can be prevented from rotating, there is not caused a problem that wirings from temperature-measuring elements connected to the ceramic substrate or from resistance heating elements are twisted and are detached. Also, in case that the ceramic substrate has a temperature distribution, dispersion in performance of respective silicon wafers increases significantly if the temperature distribution moves by the rotation of the ceramic substrate. In the present invention, however, such a problem does not arise as well.

In case that a resistance heating element is formed inside the ceramic substrate or on the surface of the ceramic substrate in the present invention, the ceramic substrate functions as a hot plate. In case that an electrostatic electrode is formed inside the ceramic substrate, the ceramic substrate functions as an electrostatic chuck.

In case that a chuck top conductor layer is formed on the surface of the ceramic substrate and a guard electrode and/or a ground electrode is/are formed inside the ceramic substrate, the ceramic substrate functions as a wafer prober.

### Brief Description of the Drawings

Fig. 1 is a bottom face view schematically illustrating a ceramic heater which is an example of the ceramic substrate of the present invention.
Fig. 2(a) is an exploded perspective view illustrating a state that a fixing member is used to fit the ceramic substrate illustrated in Fig. 1 into a supporting case, and Fig. 2(b) is a partially enlarged plane view schematically illustrating the vicinity of a notch.
Fig. 3 is a partially enlarged sectional view schematically illustrating a part of the ceramic heater illustrated in Fig. 1.
Fig. 4(a) is a perspective view schematically illustrating another embodiment of the ceramic substrate of the present invention, and Fig. 4(b) is a perspective view schematically illustrating a further another embodiment thereof.
Fig. 5 is a sectional view schematically illustrating a state that a ceramic substrate accordingto the present invention is fitted into another supporting case.
Fig. 6(a) is a vertical sectional view schematically illustrating an electrostatic chuck, and Fig. 6 (b) is a sectional view taken along A-A line of the electrostatic chuck illustrated in Fig. 6(a).
Fig. 7 is a horizontal sectional view schematically illustrating another example of an electrostatic electrode embedded in the electrostatic chuck.
Fig. 8 is a horizontal sectional view schematically illustrating further another example of an electrostatic electrode embedded in the electrostatic chuck.
Fig. 9 is a sectional view schematically illustrating a wafer prober which is one example of the ceramic substrate of the present invention.
Fig. 10 is a plane view of the wafer prober illustrated in Fig. 9.
Fig. 11 is a sectional view taken along A-A line in the wafer prober illustrated in Fig. 9.
Figs. 12(a) to 12(d) are sectional views schematically illustrating one example of a process for producing a ceramic heater according to the present invention.
Fig. 13 is an exploded perspective view schematically illustrating a state that a fixing member is used to fit a ceramic substrate of a ceramic heater of the prior art into a supporting case.

### Explanation of symbols

- 2: chuck top conductor layer
- 3, 11, 21, 71, 81: ceramic substrate
- 5: guard electrode
- 6: ground electrode
- 7: groove
- 8: suction hole
- 10: ceramic heater
- 11a: heating face
- 11b: bottom face
- 12a to 12d, 24, 32, 41: resistance heating element
- 13a to 13f: terminal portion
- 14: bottomed hole
- 15: through hole
- 16 .: lifter pin
- 17: external terminal
- 18: notch
- 19: silicon wafer
- 20, 70, 80: electrostatic chuck
- 22, 72, 82a, 82b: chuck positive electrostatic layer
- 23, 73, 83a, 83b: chuck negative electrostatic layer
- 25: ceramic dielectric film
- 28: temperature-measuring element
- 37: blind hole
- 38: conductor-filled through hole
- 52: electrode non-formed portion
- 61: heat insulating member
- 62: supporting case
- 62a: main body
- 62b: substrate-receiving portion
- 62c: bottom plate-receiving portion
- 63: metal wire
- 64: bottom plate
- 64a: through hole
- 65: coolant introducing pipe
- 66: conductive wire
- 69: guide pipe
- 120: metal covering layer
- 130: fixing member
- 131: washer
- 150: supporting case

### Detailed Disclosure of the Invention

The ceramic substrate of the present invention will be described hereinafter.

The ceramic substrate of the present invention is a ceramic substrate having a conductor layer formed inside thereof or on the surface thereof,
wherein a notch is formed.

First, a hot plate (which may be referred to as a ceramic heater) wherein resistance heating elements are formed as conductor layers on the surface of a ceramic substrate or inside the ceramic substrate will be described.

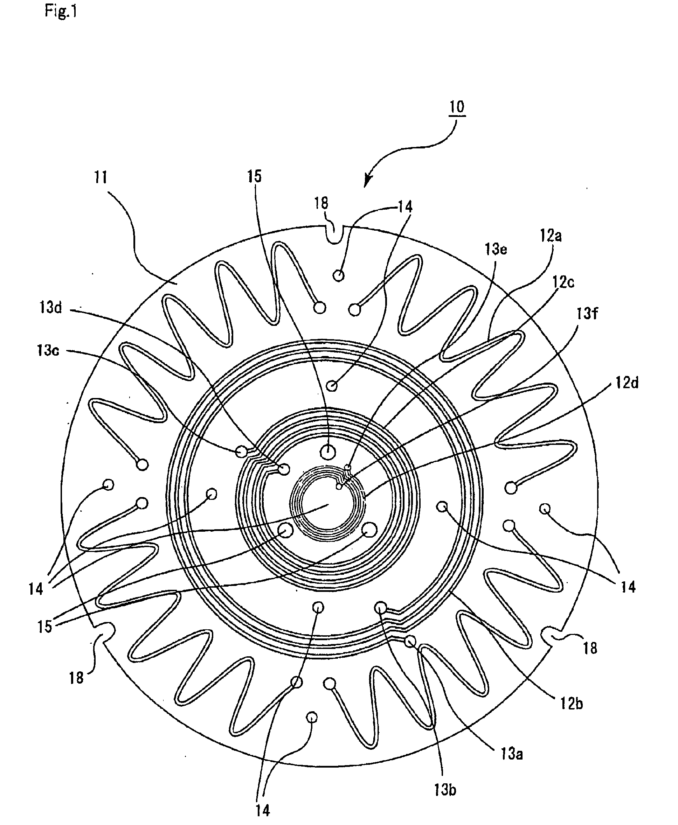

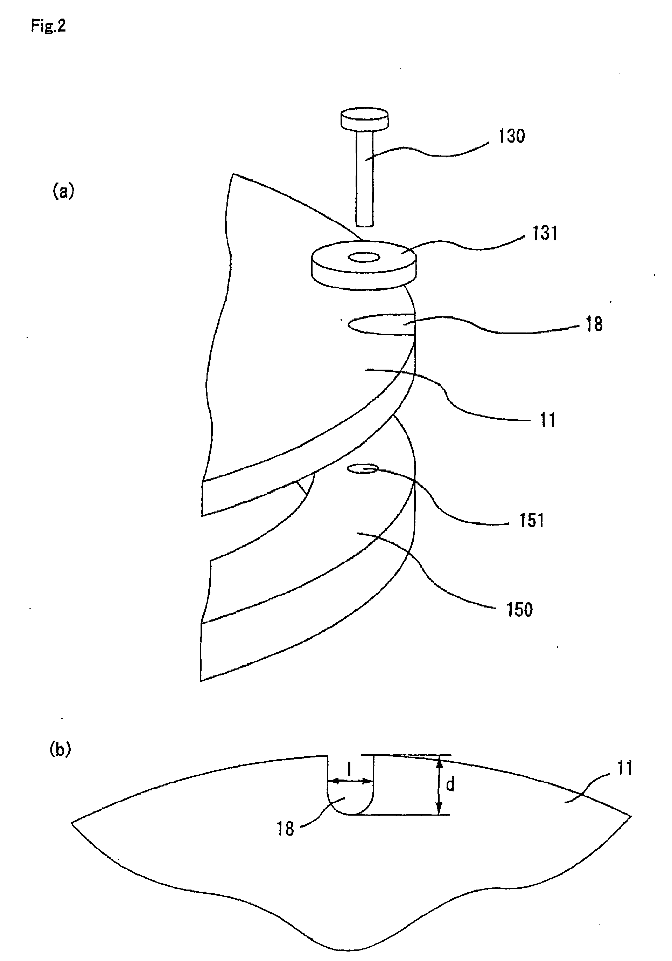

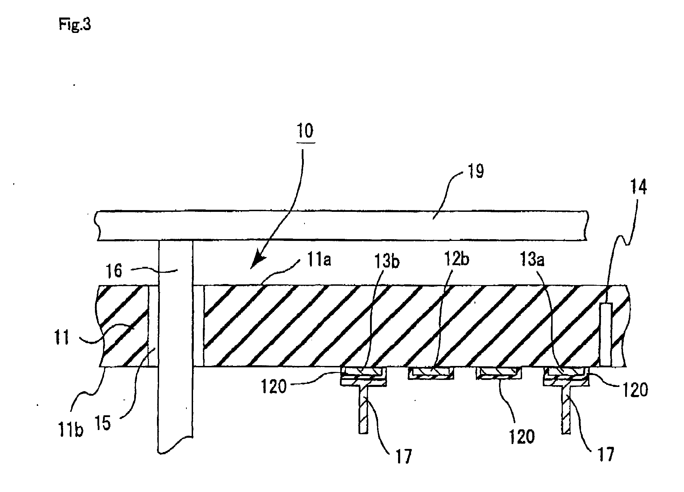

Fig. 1 is a bottom face view schematically illustrating a ceramic heater which is an example of the ceramic substrate of the present invention. Fig. 2(a) is an exploded perspective view illustrating a state that a fixing member is used to fit the ceramic substrate illustrated in Fig. 1 into a supporting case, and Fig. 2(b) is a partially enlarged plane view schematically illustrating the vicinity of a notch. Fig. 3 is a partially enlarged sectional view schematically illustrating one part of the ceramic heater illustrated in Fig. 1.

As illustrated in Fig. 1, a ceramic substrate 11 is formed into a disc form. Three notches 18 are formed at the circumferential rim portion of this ceramic substrate 11. On the bottom face of the ceramic substrate 11, resistance heating elements 12a composed of circuits having a bending line-shape are formed near the circumferential rim portion thereof, and resistance heating elements 12b to 12d having a substantially concentric circles shape are formed in the inner portion of the resistance heating element 12a. These circuits are designed to be combined with each other so as to make the temperature of the heating face 11a even.

A metal covering layer 120 is formed on the resistance heating elements 12a to 12d to prevent them from being oxidized. Terminal portions 13a to 13f for input and output are formed at both ends thereof. Furthermore, external terminals 17 are jointed to the terminal portions 13a to 13f with solder and the like, as illustrated in Fig. 3. Sockets having wiring, and so on, which are not illustrated in Fig. 3, are connected to the external terminals 17, so as to attain connection to a power source.

In the ceramic substrate illustrated in Fig. 1, the resistance heating elements 12a to 12d are formed on its bottom face. However, the resistance heating elements may be formed inside the ceramic substrate. In this case, connection to a power source can be attained by forming conductor-filled through holes just under end portions of the resistance heating elements and forming blind holes to expose the conductor-filled through holes.

In the ceramic substrate 11, bottomed holes 14, into which temperature-measuring elements will be inserted, are formed, and through holes 15, into which lifter pins 16 will be inserted, are formed in portions near the center thereof.

The lifter pins 16, on which a silicon wafer 19 can be put, can be moved up and down. In this way, the silicon wafer 19 can be delivered to a non-illustrated carrier machine or the silicon wafer 19 can be received from the carrier machine. Additionally, the silicon wafer 19 can be put on the heating face 11a of the ceramic substrate 11 and be heated, or the silicon wafer 19 can be supported in the state that it is 50 to 2000 µm apart from the heating face 11a, and be heated.

It is allowable to form through holes or concave portions in the ceramic substrate 11, insert supporting pins whose tips are in an aspire shape or a hemispherical shape into the through holes or the concave portions, fix the supporting pins in the state that the pins are slightly projected from the ceramic substrate 11, and support the silicon wafer 19 by the supporting pins, thereby heating the silicon wafer in the state that the silicon wafer is 50 to 2000 µm apart from the heating face 11a.

As described above, in this ceramic heater 10, the three notches 18 are formed at the circumferential rim portion of the ceramic substrate 11. However, the number of the notches 18 is not limited to 3 and may be 2, or 4 or more if the notches make it possible to fix the ceramic substrate 11 securely to the supporting case. In order to fix the ceramic substrate 11 horizontally and stably into the supporting case, it is desired that the notches 18 be uniformly formed at the circumferential rim portion of the ceramic substrate 11.

The size of the notches 18 is appropriately adjusted dependently on the size of fixing members 130 to be used and the ceramic substrate 11, and so on. It is desired that the width 1 is from 1 to 10 mm and the depth d is from 1 to 10 mm (reference to Fig. 2(b)). The shape of the notches 18 is desirably a shape formed by a curved face, for example, a U-shape when viewed from the above as illustrated in Fig. 2. If notches such as rectangular or V figure-shaped notches when viewed from the above are formed, the notches have edges and stress concentrates into the edges so that a crack is easily generated.

As illustrated in Fig. 2, when this ceramic substrate 11 is fixed into the supporting case 150, by inserting the fixing members 130 into the notches 18 through washers 131 and screwing the supporting members 130 into through holes 150, wherein threads are cut, of the supporting case 150, the ceramic substrate is fixed into the supporting case. Bolts and nuts may be used as the fixing members to fix the ceramic substrate. A heat insulating member, which is not illustrated and is made of a heat-resistant resin such as polyimide, or an inorganic material such as a ceramic, maybe interposed between the ceramic substrate 11 and the supporting case in the same manner as in the prior art.

The fixing members 130 are not particularly limited. Examples thereof may be bolts made of a metal and the like. The washers 131 are not particularly limited. Examples thereof may be washers made of a metal a heat-resistant resin, or a ceramic such as alumina.

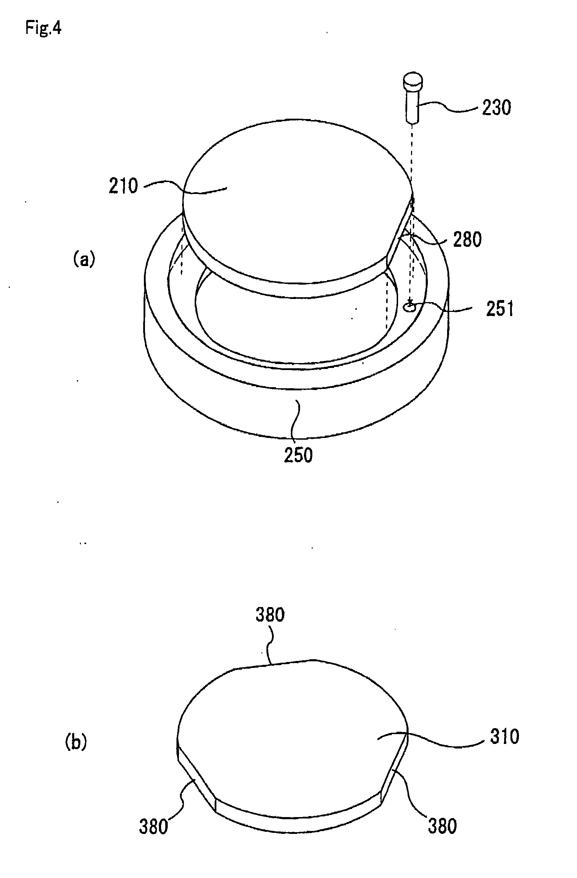

Fig. 4(a) is an exploded perspective view schematically illustrating another embodiment of the ceramic substrate of the present invention, and Fig. 4(b) is a perspective view schematically illustrating a further another embodiment thereof.

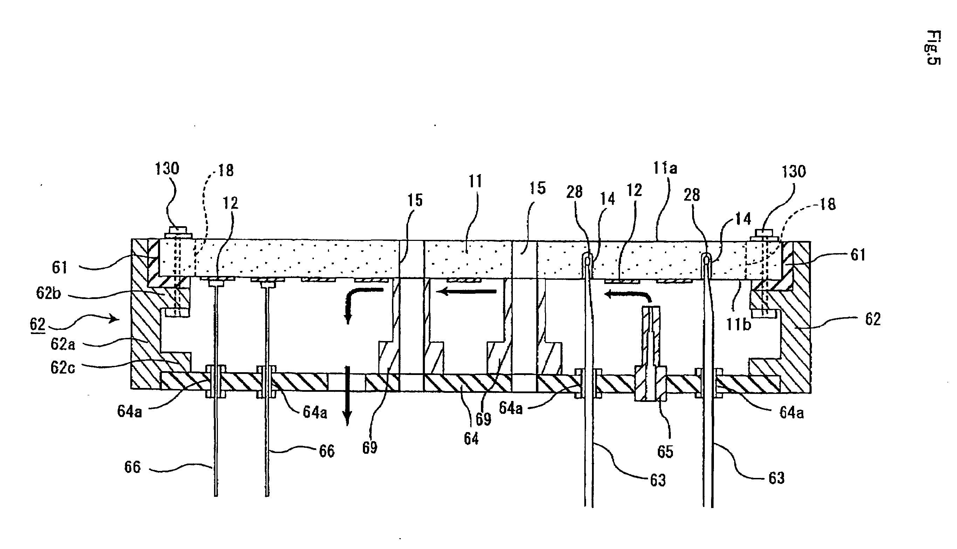

As illustrated in Fig. 4(a), in the present invention, a notch 280 may be formed by cutting a part of the side face of a ceramic substrate 210 straightly. In this case, the ceramic substrate 210 can be prevented from rotating by fitting the ceramic substrate 210 into a supporting case 250 in such a manner that a through hole 251 formed in the supporting case 250 is exposed in the portion of the notch 280, and then inserting a rotation-blocking pin 230 into the through hole 251. As illustrated in Fig. 5, in this case, the ceramic substrate 210 is desirably fitted into the supporting case 250 through a heat insulating member (not illustrated).

As illustrated in Fig. 4(b), plural straight notches 380 may be formed in a ceramic substrate 310.

Fig. 5 is a sectional view schematically illustrating a state that the ceramic substrate 11 having such a structure is fitted into a supporting case having a structure different from that in Fig. 1.

The ceramic substrate 11 having the notches 18 is fitted into the upper portion of a cylindrical supporting case 62 through a heat insulating member 61, and the fixing members 130 are passed through the notches 18 and through holes in the heat insulating members 61 and screwed into threaded holes formed in a substrate-receiving portion 62b of the supporting case 62. In this way, the ceramic substrate 11 is fixed into the supporting case 62.

As described above, in the supporting case 62, a substrate-receiving portion 62b, which has a circular ring shape, for fixing the ceramic substrate 11 is formed inside the upper portion of a main body 62a having a cylindrical shape, and further a bottom plate-receiving portion 62c having a circular ring shape is formed in the lower portion of the main body 62a. A bottom plate 64 is fixed onto this bottom plate-receiving portion 62c.

The ceramic substrate 11 is constituted in substantially the same manner as the ceramic heater 10 illustrated in Fig. 1. Conductive wires 66 having a T figure-shaped tip are connected to end portions of the resistance heating elements 12 with solder and the like. On the other hand, temperature-measuring elements 28 such as thermocouples having metal wires 63 are inserted into bottomed holes 14, and the holes are sealed with a heat-resistant resin and the like. The metal wires 63 and the conductive wires 66 are pulled out from though holes 64a made in the bottom plate 64 of the supporting case 62. These wires may be accommodated in an insulating member set up inside the supporting case and pulled out collectively from the through hole on the bottom. In this case, the respective wires are desirably coated with insulating covering members.

Incidentally, just under the through holes 15 formed in the ceramic substrate 11, guide ducts 69 are set up so as to be interconnected with the through holes 15 in such a manner that lifter pins (not illustrated) can be smoothly passed through thereinto.

The ceramic substrate of the present invention may be fixed onto the supporting case through the heat insulating member and the like as illustrated in Fig. 1, or fitted into the upper portion of the supporting case through the heat insulating member and the like as illustrated in Fig. 5.

Examples of the pattern of the resistance heating elements 12 include the combination of the concentric circles-like shape with the bending line shape illustrated in Fig. 1; single patterns such as a concentric circles-like shape and the like, a spiral shape and an eccentric circles-like shape; and combinations of these with a bending line shape and the like.

In the above-mentioned ceramic heater, the number of the circuit(s) composing the above-mentioned resistance heating element(s) is not particularly limited if the number is 1 or more. In order to heat the heating face evenly, it is desired that plural circuits are formed, and it is particularly preferred that a combination of plural concentric circles-like circuits with circuits in a bending line form, as illustrated in Fig. 1, is used.

In the ceramic heater illustrated in Fig. 1, the resistance heating elements are formed on the bottom face, but the resistance heating elements may be formed inside the ceramic substrate.

In case that the resistance heating elements are formed inside the ceramic substrate, the positions for forming them are not particularly limited. It is preferred to form at least one layer thereof at a position from the bottom face of the ceramic substrate up to 60% of the thickness thereof. This is because heat diffuses during the period when the heat is conducted up to the heating face, so that the temperature of the heating face becomes even.

When the resistance heating elements are formed inside the ceramic substrate or on the bottom face thereof, a conductor containing paste comprising a metal or a conductive ceramic is preferably used.

That is, in case that the resistance heating elements are formed inside the ceramic substrate, a conductor containing paste layer is formed on a green sheet and subsequently such green sheets are laminated and fired to form the resistance heating elements inside. On the other hand, in case that the resistance heating elements are formed on the bottom face thereof, firstly, firing is usually performed to produce a ceramic substrate and subsequently a conductor containing paste layer is formed on the surface thereof and fired to produce the resistance heating elements.

The above-mentioned conductor containing paste is not particularly limited, and is preferably a paste comprising not only metal particles or a conductive ceramic for keeping electrical conductivity but also a resin, a solvent, a thickener and so on.

Examples of the metal particles preferably include a noble metal (gold, silver, platinum or palladium), lead, tungsten, molybdenum, nickel and the like. These may be used alone or in combination of two or more. This is because: these metals are not relatively easily oxidized, and have a resistance value sufficient for generating heat.

Examples of the above-mentioned conductive ceramic include carbides of tungsten and molybdenum. These may be used alone or in combination of two or more. The particle diameter of these metal particles or the conductive ceramic is preferably from 0.1 to 100 µm. If the particle diameter is too fine, that is, below 0.1 µm, they are easily oxidized. On the other hand, if the particle diameter is over 100 µm, they are not easily sintered so that the resistance value becomes large.

The shape of the above-mentioned metal particles may be spherical or scaly. When these metal particles are used, they may be a mixture of spherical particles and scaly particles.

In case that the metal particles are scaly or made of a mixture of spherical particles and scaly particles, metal oxides between the metal particles are easily retained and adhesiveness between the resistance heating elements and the ceramic substrate is made sure. Moreover, the resistance value can be made large. Thus, this case is profitable.

Examples of the resin used in the conductor containing paste include epoxy resins, phenol resins and the like. Examples of the solvent include isopropyl alcohol and the like. Examples of the thickener are cellulose and the like.

When the conductor containing paste for the resistance heating elements is formed on the surface of the ceramic substrate, it is preferred to add a metal oxide besides the metal particles to the conductor containing paste and sinter the metal particles and the metal oxide. By sintering the metal oxide together with the metal particles in this way, the ceramic substrate can be closely adhered to the metal particles.

The reason why the adhesiveness to the ceramic substrate by mixing the metal oxide is improved is unclear, but would be based on the following. The surface of the metal particles or the surface of the ceramic substrate made of a non-oxide is slightly oxidized so that an oxidized film is formed thereon. Pieces of this oxidized film are sintered and integrated with each other through the metal oxide so that the metal particles and the ceramic are closely adhered to each other. In case that the ceramic constituting the ceramic substrate is an oxide, a conductor layer having superior adhesiveness is formed because the surface thereof is naturally made of the oxide.

A preferred example of the metal oxide is at least one selected from the group consisting of lead oxide, zinc oxide, silica, boron oxide (B₂O₃), alumina, yttria, and titania.

These oxides make it possible to improve adhesiveness between the metal particles and the ceramic substrate without increasing the resistance value of the resistance heating elements.

When the total amount of the metal oxides is set to 100 parts by weight, the weight ratio of lead oxide, zinc oxide, silica, boron oxide (B₂O₃), alumina, yttria and titania is as follows: lead oxide: 1 to 10, silica: 1 to 30, boron oxide: 5 to 50, zinc oxide: 20 to 70, alumina: 1 to 10, yttria: 1 to 50 and titania: 1 to 50. The ratio is preferably adjusted within the scope that the total thereof is not over 100 parts by weight.

By adjusting the amounts of these oxides within these ranges, the adhesiveness to the ceramic substrate can be particularly improved.

The addition amount of the metal oxides to the metal particles is preferably 0.1% by weight or more and less than 10% by weight. The area resistivity when the conductor containing paste having such a structure is used to form the resistance heating elements is preferably from 1 to 45 mΩ/□.

If the area resistivity is over 45 mΩ/□, the calorific value for an applied voltage becomes too small so that, in the ceramic substrate wherein resistance heating elements are set on its surface, its calorific value is not easily controlled. If the addition amount of the metal oxides is 10% by weight or more, the area resistivity exceeds 50 mΩ/□. As a result, the calorific value becomes too large so that temperature-control becomes difficult and the evenness of the temperature distribution deteriorates.

In case that the resistance heating elements are formed on the surface of the ceramic substrate, a metal covering layer is preferably formed on the surface of the resistance heating elements. The metal covering layer prevents a change in the resistance value based on oxidization of the inner metal sintered body. The thickness of the formed metal covering layer is preferably from 0.1 to 10 µm.

The metal used when the metal covering layer is formed is not particularly limited if the metal is a metal which is non-oxidizable. Specific examples thereof include gold, silver, palladium, platinum, nickel and the like. These may be used alone or in combination of two or more. Among these metals, nickel is preferred.

In case that the resistance heating elements are formed inside the ceramic substrate, no coating is necessary since the surface of the above-mentioned resistance heating elements is not oxidized.

As described above, the resistance heating elements can be formed by using the conductor containing paste, or can be formed by embedding metal wires in a formed body.

The ceramic substrate of the present invention can be used at 150 °C or higher, and is desirably used at 200 °C or higher.

In case that the conductor layer formed in the ceramic substrate of the present invention is the resistance heating elements, the ceramic substrate can be used as a ceramic heater.

The ceramic material constituting this ceramic substrate is not particularly limited. Examples thereof include nitride ceramics, carbide ceramics, oxide ceramics and the like.

Examples of the nitride ceramics include metal nitride ceramics such as aluminum nitride, silicon nitride, boron nitride, titanium nitride and the like.

Examples of the carbide ceramics include metal carbide ceramics such as silicon carbide, zirconium carbide, titanium carbide, tantalum carbide, tungsten carbide and the like.

Examples of the oxide ceramics include metal oxide ceramics such as alumina, zirconia, cordierite, mullite ant the like.

These ceramics may be used alone or in combination of two or more thereof.

Among these ceramics, nitride ceramics and carbide ceramics are more preferred than oxide ceramics. This is because they have a high thermal conductivity.

Aluminum nitride is most preferred among nitride ceramics since its thermal conductivity is highest, that is, 180 W/m · K.

The above-mentioned ceramic material may comprise a sintering aid. Examples of the sintering aid include alkali metal oxides, alkali earth metal oxides and rare element oxides and the like. CaO, Y₂O₃, Na₂O, Li₂O and Rb₂O are particularly preferred among these sintering aids. The content of these sintering aids is desirably from 0.1 to 10 % by weight. Also, alumina may be contained.

In the ceramic substrate according to the present invention, its brightness is desirably N6 or less as the value based on the rule of JIS Z 8721. This is because the ceramic substrate having such a brightness is superior in radiant heat capacity and covering-up ability. The surface temperature of such a ceramic substrate can be accurately measured with a thermoviewer.

The brightness N is defined as follows: the brightness of ideal black is made to 0; that of ideal white is made to 10; respective colors are divided into 10 parts in the manner that the brightness of the respective colors is recognized stepwise between the brightness of black and that of white at equal intensity intervals of perceptual brightness; and the resultant parts are indicated by symbols N0 to N10, respectively.

Actual brightness is measured by comparison with color charts corresponding to N0 to N10. One place of decimals in this case is made to 0 or 5.

The ceramic substrate having such properties can be obtained by incorporating 100 to 5000 ppm of carbon into the ceramic substrate. The carbon may be either amorphous or crystalline. The amorphous carbon makes it possible to suppress a drop in the volume resistivity of the ceramic substrate at high temperature, and the crystalline carbon makes it possible to suppress a drop in the thermal conductivity of the ceramic substrate at high temperature. Therefore, the kind of carbon can be appropriately selected dependently on the purpose of the substrate to be produced, and so on.

The amorphous carbon can be obtained by firing, for example, a hydrocarbon made of only C, H and O, preferably a saccharide in the air. As the crystalline carbon, graphite powder and the like can be used.

Carbon can be obtained by decomposing an acrylic resin thermally in an inert gas atmosphere and then heating and pressing the resin. By changing the acid value of this acrylic resin, the degree of crystallinity (amorphousness) can be adjusted.

The shape of the ceramic substrate is preferably a disc shape. The diameter thereof is preferably 200 mm or more, most preferably 250 mm or more.

For the ceramic substrate having a disc shape, temperature-evenness is required. This is because the temperature thereof more easily becomes uneven, as the substrate has a larger diameter,.

The thickness of the ceramic substrate is preferably 50 mm or less, more preferably 20 mm or less, and most preferably from 1 to 5 mm.

If the thickness of the am ceramic substrate is too thin, a warp is easily generated when the ceramic substrate is heated at high temperature. On the other hand, if the thickness is too thick, the heat capacity thereof becomes too large so that the temperature-rising/falling property thereof deteriorates.

The porosity of the ceramic substrate is preferably 0, or 5% or less. The porosity is measured by Archimedes method.

This is because a drop in the thermal conductivity at high temperature and the generation of a warp can be suppressed.

If necessary, in the present invention a thermocouple may be buried in the ceramic substrate. This is because the thermocouple makes it possible to measure the temperature of the resistance heating element and, on the basis of the resultant data, voltage or current amount is changed so that the temperature can be controlled.

The size of the connecting portions of metal wires of the thermocouples is the same as the strand diameter of the respective metal wires or more, and the size is preferably 0.5 mm or less. Such a structure makes the heat capacity of the connecting portion small, and causes temperature to be correctly and rapidly converted to a current value. For this reason, temperature controllability is improved so that temperature distribution in the heated surface of the wafer becomes small.

Examples of the thermocouple include K, R, B, S, E, J and T type thermocouples, described in JIS-C-1602 (1980) and the like.

The above-mentioned ceramic heater is a device wherein only the resistance heating elements are set up on the surface of the ceramic substrate or inside the ceramic substrate. This makes it possible to heat an object to be heated, such as a silicon wafer and the like, up to a given temperature.

Specific examples of other devices of the ceramic substrate of the present invention include an electrostatic chuck, a wafer prober, a susceptor and the like.

In case that the conductor layer formed inside the ceramic substrate of the present invention is an electrostatic electrode, this ceramic substrate functions as an electrostatic chuck.

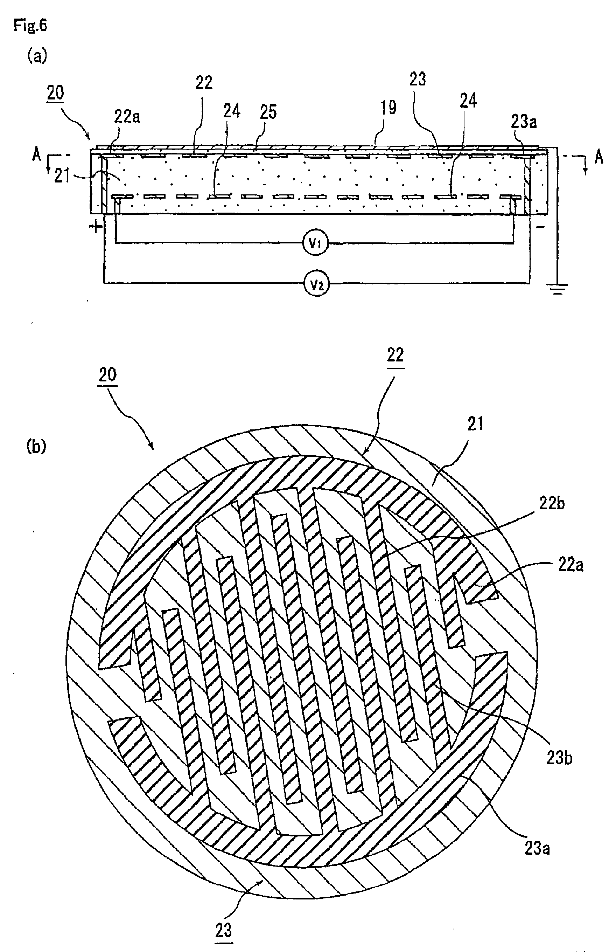

Fig. 6(a) is a vertical sectional view schematically illustrating an electrostatic chuck, and (b) is a sectional view taken along A-A line of the electrostatic chuck illustrated in (a).

In this electrostatic chuck 20, chuck positive and negative electrode layers 22 and 23 are buried in a ceramic substrate 21. A ceramic dielectric film 25 is formed on the electrodes. Resistance heating elements 24 are disposed inside the ceramic substrate 21 so that a silicon wafer 19 can be heated. If necessary, an RF electrode may be buried in the ceramic substrate 21.

As shown in (b), the electrostatic chuck 20 is usually made in a circular form when viewed from the above. The chuck positive electrostatic layer 22 composed of a semicircular arc part 22a and a combteeth-shaped part 22b and the chuck negative electrostatic layer 23 composed of a semicircular arc part 23a and a combteeth-shaped part 23b, which are shown in Fig. 6, are arranged oppositely to each other inside the ceramic substrate 21 so that the combteeth-shaped parts 22b and 23b cross each other.

When this electrostatic chuck is used, the positive side and the negative side of a DC power source are connected to the chuck positive electrostatic layer 22 and chuck negative electrostatic layer 23, respectively, and then a direct current is applied thereto. In this way, the semiconductor wafer put on this electrostatic chuck is electrostatically adsorbed.

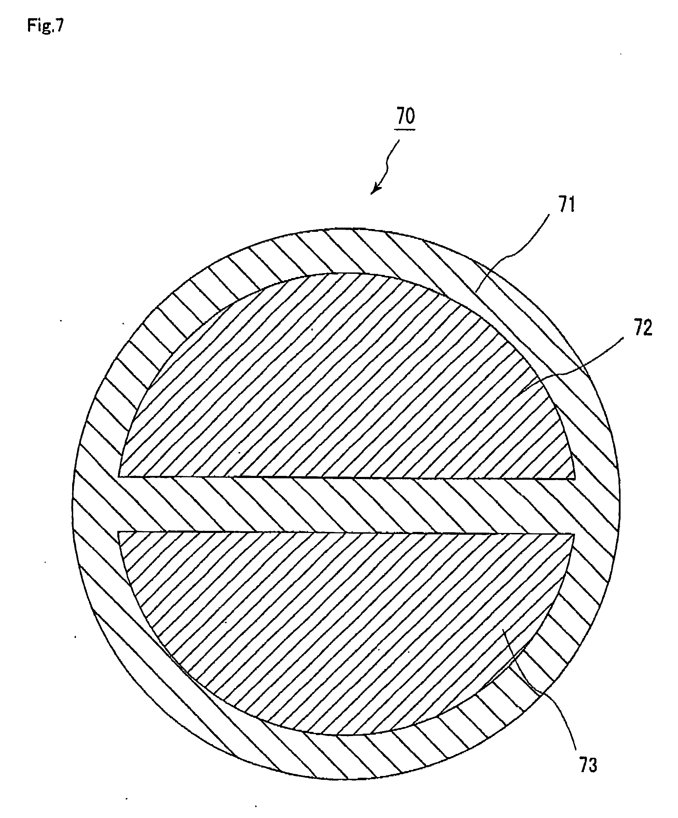

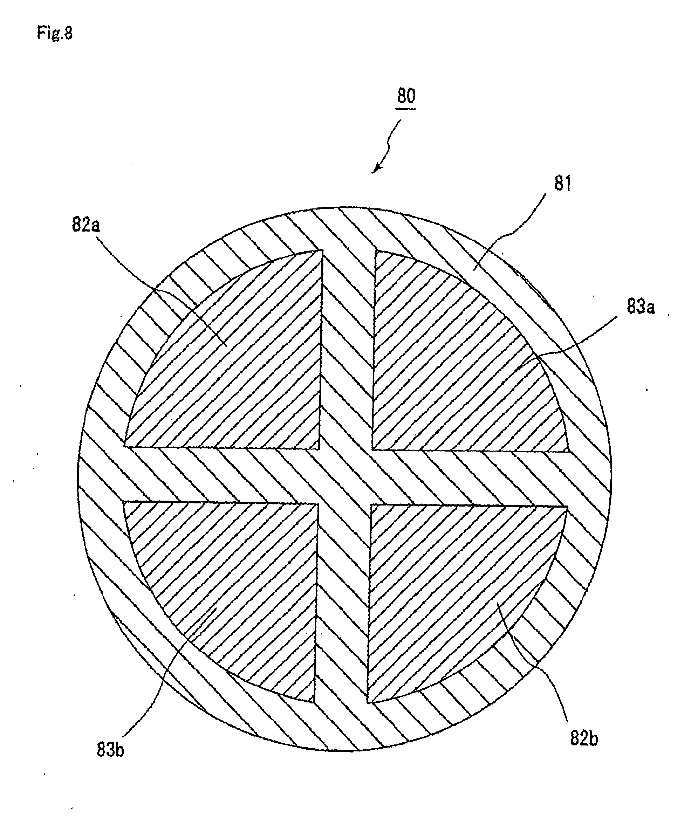

Figs. 7 and 8 are horizontal sectional views, each of which schematically shows electrostatic electrodes in a different electrostatic chuck. In an electrostatic chuck 70 shown in Fig. 7, a chuck positive electrostatic layer 72 and a chuck negative electrostatic layer 73 each of which in a semicircular form are formed inside a ceramic substrate 71. In an electrostatic chuck 80 shown in Fig. 8, chuck positive electrostatic layers 82a and 82b and chuck negative electrostatic layers 83a and 83b, each of which has a shape obtained by dividing a circle into 4 parts, are formed inside a ceramic substrate 81. The two chuck positive electrostatic layers 82a and 82b and the two chuck negative electrostatic layers 83a and 83b are formed to cross each other.

In case that an electrode having such a shape that an electrode having a circular shape and the like shape is divided is made, the number of divided pieces is not particularly limited and may be 5 or more. Its shape is not limited to a sector.

In case that a chuck top conductor layer is deposited on the surface of the ceramic substrate of the present invention; and a guard electrode and a ground electrode are disposed inside thereof, the above-mentioned substrate functions as a wafer prober.

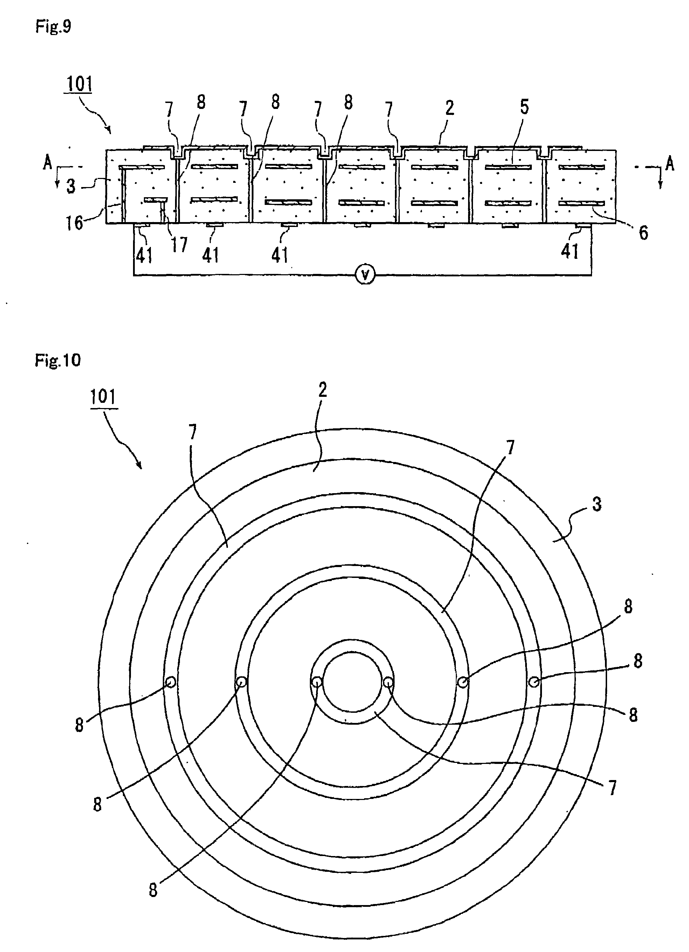

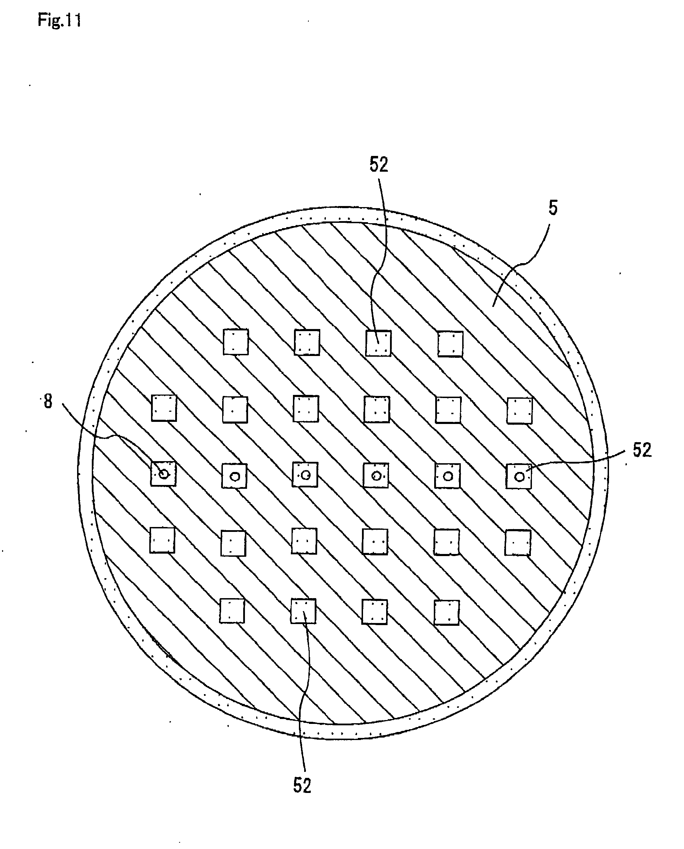

Fig. 9 is a sectional view that schematically shows a wafer prober, which is an example of the ceramic substrate of the present invention. Fig. 10 is a plane view thereof, and Fig. 11 is a sectional view taken along A-A line in the wafer prober shown in Fig. 9.

In this wafer prober 101, grooves 7 in the form of concentric circles are made in the surface of a ceramic substrate 3, which is in a circle form when viewed from the above. Moreover, suction holes 8 for sucking a silicon wafer are made in a part of the grooves 7. A chuck top conductor layer 2 for connecting electrodes of the silicon wafer is formed, in a circular form, in a greater part of the ceramic substrate 3 including the grooves 7.

On the other hand, resistance heating elements 41 wherein a pattern of concentric circles-like is combined with a pattern of bending lines as shown in Fig. 1 are disposed on the bottom face of the ceramic substrate 3 to control the temperature of the silicon wafer. External terminals are connected and fixed to terminal portions formed at both ends of the resistance heating element 41. Inside the ceramic substrate 3, a guard electrode 5 and a ground electrode 6, in the form of a lattice as shown in Fig. 11, are disposed to remove stray capacitors or noises. Rectangular electrode non-forming portions 52 are positioned in the guard electrode 5 in order to adhere the ceramic substrates on and beneath the guard electrode 5 to each other.

After a silicon wafer, on which integrated circuits are formed, is put on the wafer prober having such a structure, a probe card having a tester pin is pressed against this silicon wafer. Then, a voltage is applied thereto while the silicone wafer is heated or cooled, so that a continuity test for testing whether the circuit works without problem or not can be performed.

Next, a process for producing a ceramic heater will be described as an example of the process for producing the ceramic substrate of the present invention.

Firstly, the following describes a process for producing a ceramic heater wherein the resistance heating elements 12 are formed on the bottom face of the ceramic substrate 11 shown in Fig 1.

### (1) Step of forming the ceramic substrate

A slurry is prepared by blending powder made of a nitride ceramic, such as the above-mentioned aluminum nitride with a sintering aid such as yttria, a binder and so on based on the necessity. Thereafter, this slurry is made into a granular form by spray-drying and the like. The granule is put into a mold and pressed to be formed into a plate form and the like form. Thus, a raw formed body (green) is formed. At this time, carbon may be contained therein.

Next, the following are formed in the raw formed body if necessary: portions that will be the through holes 15 into which supporting pins 16 for supporting a silicon wafer will be inserted; portions that will be the bottomed holes 14 in which temperature-measuring elements such as thermocouples will be embedded; portions that will be the notches 18 into which the fixing members will be inserted, and so on. After firing, a drill, a cutting member and the like may be used to form the through holes 15, the bottomed holes 14, the notches 18 and so on in the produced ceramic substrate.

Next, this raw formed body is heated and fired to be sintered. Thus, a plate-shaped body made of the ceramic is produced. Thereafter, the plate-shaped body is processed into a given shape to produce the ceramic substrate 11. The shape of the raw formed body may be such a shape that the sintered body can be used as it is. By heating and firing the raw formed body under pressure, the ceramic substrate 11 having no pores can be produced. It is sufficient that the heating and the firing are performed at sintering temperature or higher. The firing temperature is from 1000 to 2500 °C for nitride ceramics.

### (2) Step of printing a conductor containing paste on the ceramic substrate

A conductor containing paste is generally a fluid comprising metal particles, a resin and a solvent, and has a high viscosity. This conductor containing paste is printed in portions where resistance heating elements are to be arranged by screen printing and the like, to form a conductor containing paste layer. Since it is necessary that the resistance heating elements make the temperature of the whole of the resistance heating elements even, the conductor containing paste is desirably printed into a pattern of concentric circles-like combined with bending lines, as shown in Fig. 1. The conductor containing paste is desirably formed in the manner that a section of the resistance heating elements 12 after the firing is rectangular and flat.

### (3) Firing of the conductor containing paste

The conductor containing paste layer printed on the bottom face of the ceramic substrate 11 is heated and fired to remove the resin and the solvent and sinter the metal particles. Thus, the metal particles are baked onto the bottom face of the ceramic substrate 11 to form the resistance heating elements 12. The temperature for heating and firing is preferably from 500 to 1000 °C.

If the above-mentioned oxides are added to the conductor containing paste, the metal particles, the ceramic substrate and the metal oxides are sintered to be integrated with each other. Thus, the adhesiveness between the resistance heating elements and the ceramic substrate is improved.

### (4) Step of forming a metal covering layer

A metal covering layer is desirably formed on the surface of the resistance heating elements 12.

The metal covering layer can be formed by electroplating, electroless plating, sputtering and the like. From the viewpoint of mass-productivity, electroless plating is optimal.

### (5) Fitting of terminal pins and so on

External terminals for connection to a power source are fitted up to end portions of the pattern of the resistance heating elements 12 with solder and the like. Thermocouples are inserted into the bottomed holes 14. The bottomed holes are sealed with a heat resistant resin such as a polyimide, thus, to produce the ceramic heater 10.

When the granule is put into the mold to form the formed body in the above-mentioned process, the resistance heating elements may be formed inside the ceramic substrate by embedding metal wires inside the granule.

An electrostatic chuck can be produced by arranging an electrostatic electrode inside the ceramic substrate when the above-mentioned ceramic heater is being produced. A wafer prober can be produced by providing a chuck top conductor layer on the heating face and then setting a guard electrode and a ground electrode inside the ceramic substrate.

In case that the electrode is set inside the ceramic substrate, it is advisable that metal foil and the like is embedded in the ceramic substrate. In case that the conductor layer is formed on the surface of the ceramic substrate, the methods of sputtering or plating may be used. These methods may be used together.

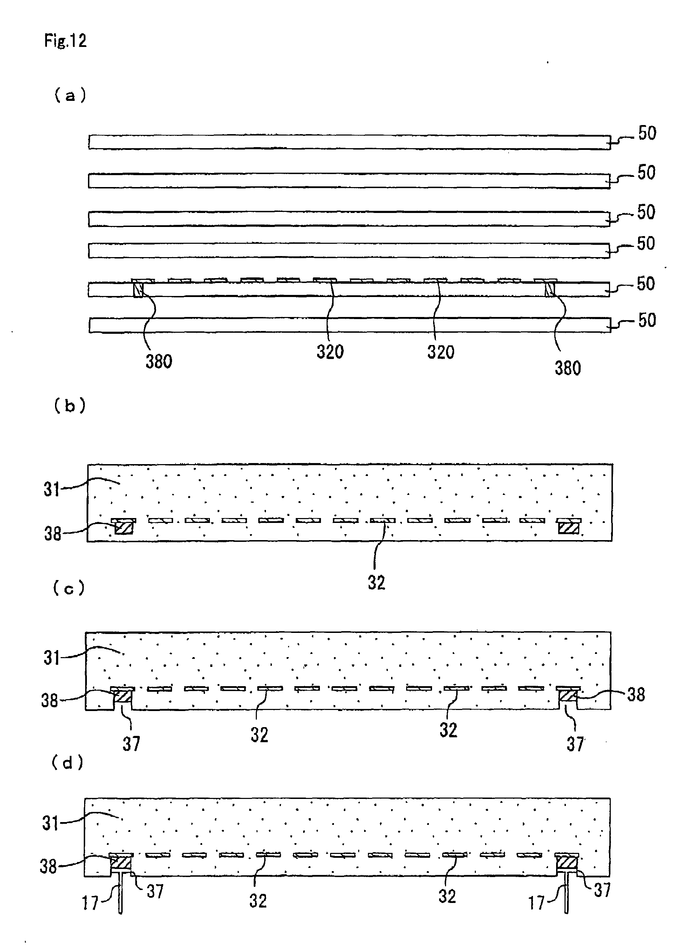

On the basis of Fig. 12, the following will describe a process for producing a ceramic heater wherein resistance heating elements are formed inside a ceramic substrate.

### (1) Step of forming the ceramic substrate

First, powder of a nitride ceramic is mixed with a binder, a solvent and so on to prepare a paste. This is used to form a green sheet.

As the above-mentioned ceramic powder, aluminum nitride, and the like can be used. If necessary, a sintering aid such as yttria may be added.

As the binder, desirable is at least one selected from an acrylic binder, ethylcellulose, butylcellosolve, and polyvinyl alcohol.

As the solvent, desirable is at least one selected from α-terpineol and glycol.

A paste obtained by mixing these is formed into a sheet form by doctor blade process, to form a green sheet 50.

The thickness of the green sheet 50 is preferably from 0.1 to 5 mm.

Next, the following are formed in the resultant green sheet if necessary: portions which will be through holes into which lifter pins for carrying a silicon wafer will be inserted; portions which will be bottomed holes in which temperature-measuring elements such as thermocouples will be embedded; portions that will be notches into which fixing members will be passed through; portions 380 which will be conductor-filled through holes for connecting the resistance heating elements to external terminals; and so on. After a green sheet lamination that will be described later is formed, the above-mentioned processing may be performed.

### (2) Step of printing a conductor containing paste on the green sheet

A metal paste or a conductor containing paste containing a conductive ceramic is printed on the green sheet 50, to form a conductor containing paste layer 320.

This conductor containing paste contains metal particles or conductive ceramic particles.

The average particle diameter of tungsten particles or molybdenum particles is preferably from 0.1 to 5 µm. If the average particle is below 0.1 µm or over 5 µm, the conductor containing paste is not easily printed.

Such a conductor containing paste may be a composition (paste) obtained by mixing, for example, 85 to 87 parts by weight of the metal particles or the conductive ceramic particles; 1.5 to 10 parts by weight of at least one binder selected from acrylic binders, ethylcellulose, butylcellosolve and polyvinyl alcohol; and 1.5 to 10 parts by weight of at least one solvent selected from α-terpineol and glycol.

### (3) Step of laminating the green sheets

Green sheets 50 on which no conductor containing paste is printed are laminated on the upper and lower sides of the green sheet 50 on which the conductor containing paste is printed (Fig. 12(a)).

At this time, the number of the green sheet 50 laminated on the upper side is made larger than that of the green sheet 50 laminated on the lower side to cause the position where the resistance heating elements are formed to be biased toward the bottom face.

Specifically, the number of the green sheets 50 laminated on the upper side is preferably from 20 to 50, and that of the green sheets 50 laminated on the lower side is preferably from 5 to 20.

### (4) Step of firing the green sheet lamination

The green sheet lamination is heated and pressed so as to sinter the green sheets 50 and the inner conductor containing paste layer 320 (Fig. 12(b)).

The heating temperature is preferably from 1000 to 2000 °C, and the pressing pressure is preferably from 10 to 20 MPa. The heating is performed in the atmosphere of an inert gas. As the inert gas, argon, nitrogen and the like can be used.

Incidentally, after the firing, bottomed holes into which temperature-measuring elements will be inserted, and the like may be made. The bottomed holes and the like can be made by drilling or blast treatment such as sandblast after surface-grinding. Blind holes 37 are formed to expose conductor-filled through holes 38, the holes 38 being for connection to inner resistance heating elements 32 (Fig. 12(c)). External terminals 17 are inserted into the blind holes 37, and are heated and reflowed. In this way, the external terminals 17 are connected thereto (Fig. 12(d)) The heating temperature is suitably from 90 to 450 °C in the case of treatment with solder. The heating temperature is suitably from 900 to 1100 °C in the case of treatment with brazing material.

Furthermore, thermocouples and the like as temperature-measuring elements are sealed with a heat-resistant resin and the like to produce a ceramic heater.

In this ceramic heater, various operations can be performed while a silicon wafer and the like is heated or cooled; after the silicon wafer and the like is put thereon; or after the silicon wafer and the like is held by supporting pins.

An electrostatic chuck can be produced by setting an electrostatic electrode inside the ceramic substrate when the above-mentioned ceramic heater is produced. A wafer prober can be produced by forming a chuck top conductor layer on the heating face and then setting a guard electrode and a ground electrode inside the ceramic substrate.

In case that the electrode is set inside the ceramic substrate, it is advisable that a conductor containing paste layer is formed on the surface of the green sheet in the same manner as in the case of forming the resistance heating elements. In case that the conductor containing paste is formed on the surface of the ceramic substrate, the methods of sputtering or plating may be used. These methods may be used together. The present invention will be described in more detail hereinafter.

### Best Mode for Carrying Out the Invention

### (Example 1) Production of a ceramic heater (reference to Fig. 1)

(1) A composition made of 100 parts by weight of aluminum nitride powder (made by Tokuyama Corp., average particle diameter: 1.1 µm), 4 parts by weight of yttrium oxide (Y₂O₃:yttria, average particle diameter: 0.4 µm), 12 parts by weight of an acrylic binder and an alcohol was subjected to spray-drying to make granular powder.
(2) Next, this granular powder was put into a mold and formed into a plate-shaped body to obtain a raw formed body (green).
(3) The raw formed body subjected to the above-mentioned working treatment was hot-pressed at 1800 °C and a pressure of 20 MPa to obtain an aluminum nitride sintered body having a thickness of 3 mm.
   Next, this plate-shaped body was cut out into a disk having a diameter of 210 mm to prepare a plate-shaped body (ceramic substrate 11) made of the ceramic.
   Next, this plate-shaped body was drilled and cut with a cutting member to form through holes into which lifer pins would be inserted, through holes 15 into which supporting pins for supporting a silicon wafer would be inserted, bottomed holes 14 (diameter: 1.1 mm, depth: 2 mm) into which thermocouples would be embedded, and U figure-shaped notches 18 (width: 5 mm, depth: 10 mm).
(4) A conductor containing paste was printed on the bottom face of the sintered body obtained in the (3) by screen printing. The printed pattern was a pattern wherein the shape of concentric circles-like was combined with the shape of bending lines as illustrated in Fig. 1.
   The used conductor containing paste was Solvest PS603D made by Tokuriki Kagaku Kenkyu-zyo, which is used to form plated through holes in printed circuit boards.
   This conductor containing paste was a silver-lead paste and contained 7.5 parts by weight of metal oxides made of lead oxide (5 % by weight), zinc oxide (55% by weight) , silica (10% by weight) , boron oxide (25% by weight) and alumina (5% by weight) per 100 parts by weight of silver. The silver particles had an average particle diameter of 4.5 µm, and were scaly.
(5) Next, the sintered body on which the conductor containing paste was printed was heated and fired at 780 °C to sinter silver and lead in the conductor containing paste and bake them onto the sintered body. Thus, resistance heating elements were formed. The silver-lead resistance heating elements 12 had a thickness of 5 µm, a width of 2.4 mm and an area resistivity of 7.7 mΩ/□ near its terminal portions.
(6) Next, the sintered body formed in the step (5) was immersed into an electroless nickel plating bath comprising an aqueous solution containing 80 g/L of nickel sulfate, 24 g/L of sodium hypophosphite, 12 g/L of sodium acetate, 8 g/L of boric acid, and 6 g/L of ammonium chloride to precipitate a metal covering layer 120 (nickel layer) having a thickness of 1 µm on the surface of the silver-lead resistance heating elements 12.
(7) By screen printing, a silver-lead solder paste (made by Tanaka Kikinzoku Kogyo Co.) was printed on terminal portions for attaining connection to a power source, so as to form a solder layer.
   Next, external terminals 17 made of koval were put on the solder layer and heated and reflowed at 420 °C to attach the external terminals 17 onto the terminal portions of the resistance heating elements.
(8) Thermocouples for controlling temperature were inserted into the bottomed holes and a polyimide resin was filled into the holes. The resin was cured at 190 °C for 2 hours to obtain a ceramic heater 10 (reference to Fig. 1).

### (Example 2) Production of an electrostatic chuck

(1) The following paste was used to conduct formation by a doctor blade process to obtain a green sheet of 0.47 mm in thickness: a paste obtained by mixing 100 parts by weight of aluminum nitride powder (made by Tokuyama Corp., average particle diameter: 1.1 µm), 4 parts by weight of yttria (average particle diameter: 0.4 µm), 12 parts by weight of an acrylic binder, 0.5 part by weight of a dispersant and 53 parts by weight of alcohols composed of 1-butanol and ethanol.
(2) Next, this green sheet was dried at 80 °C for 5 hours, and subsequently through holes for conductor-filled through holes for connecting resistance heating elements and external terminals were formed by punching.
(3) The following were mixed to prepare a conductor containing paste A: 100 parts by weight of tungsten carbide particles having an average particle diameter of 1 µm, 3.0 parts by weight of an acrylic binder, 3.5 parts by weight of α-terpineol solvent, and 0.3 part by weight of a dispersant. The following were mixed to prepare a conductor containing paste B: 100 parts by weight of tungsten particles having an average particle diameter of 3 µm, 1.9 parts by weight of an acrylic binder, 3.7 parts by weight of α-terpineol solvent, and 0.2 part by weight of a dispersant.
(4) The conductor containing paste A was printed on the surface of the green sheet by screen printing to form resistance heating elements. The pattern of the printing was made into the same pattern as in Example 1, which was a pattern wherein the shape of concentric circles-like was combined with bending lines. Furthermore, a conductor containing paste layer having an electrostatic electrode pattern having the shape shown in Fig. 6 was formed on other green sheets.
   Moreover, the conductor containing paste B was filled into the through holes for the conductor-filled through holes for connecting the external terminals. The electrostatic electrode pattern was composed of combteeth-shaped electrodes (22b and 23b), and 22b and 23b were connected to 22a and 23a (reference to Fig. 6(b)).
   Thirty four green sheets on which no tungsten paste was printed were stacked on the upper side (heating surface) of the green sheet that had been subjected to the above-mentioned processing, and the same thirteen green sheets were stacked on the lower side thereof. The green sheet on which the conductor containing paste layer having the electrostatic electrode pattern was printed was stacked thereon. Furthermore, two green sheets on which no tungsten paste was printed were stacked thereon. The resultant was pressed at 130 °C and a pressure of 8 MPa to form a lamination.
(5) Next, the resultant lamination was degreased at 600 °C in the atmosphere of nitrogen gas for 5 hours and hot-pressed at 1890 °C and a pressure of 15 MPa for 3 hours to obtain an aluminum nitride plate-shaped body of 3 mm in thickness. This was cut into a disk of 230 mm in diameter to prepare a plate-shaped body which was made of aluminum nitride; had therein resistance heating elements 32 having a thickness of 5 µm, a width of 2.4 mm, and an area resistivity of 7.7 mΩ/□; and had a chuck positive electrostatic layer 22 and a chuck negative electrostatic layer 23 having a thickness of 6 µm.
(6) Next, the ceramic substrate 21 obtained in the (5) was ground with a diamond grindstone. Subsequently a mask was put thereon, and bottomed holes (diameter: 1.2 mm, and depth: 2.0 mm) for thermocouples were formed in the surface and a straight notch (the maximum distance from the side face: 5 mm) illustrated in Fig. 4(a) was formed at the circumferential rim portion by blast treatment with SiC and the like.
(7) Furthermore, portions where the conductor-filled through holes were made were hollowed out to form blind holes. Brazing gold made of Ni-Au was used, heated and reflowed at 700 °C to connect external terminals made of koval to the blind holes.
(8) Next, thermocouples for controlling temperature were buried in the bottomed holes to finish the production of an electrostatic chuck having the resistance heating elements having the pattern illustrated in Fig. 1.

### (Example 3) Production of a wafer prober

(1) The following paste was used to conduct formation by a doctor blade process to obtain a green sheet of 0.47 mm in thickness: a paste obtained by mixing 100 parts by weight of aluminum nitride powder (made by Tokuyama Corp., average particle diameter: 1.1 µm), 4 parts by weight of yttria (average particle diameter: 0.4 µm), 12 parts by weight of an acrylic binder, 0.5 part by weight of a dispersant, and 53 parts by weight of alcohols composed of 1-butanol and ethanol.
(2) Next, this green sheet was dried at 80 °C for 5 hours, and subsequently through holes for conductor-filled through holes for connecting electrodes to external terminals were formed by punching.
(3) The following were mixed to prepare a conductor containing paste A: 100 parts by weight of tungsten carbide particles having an average particle diameter of 1 µm, 3.0 parts by weight of an acrylic binder, 3.5 parts by weight of α-terpineol solvent, and 0.3 part by weight of a dispersant. The following were also mixed to prepare a conductor containing paste B: 100 parts by weight of tungsten particles having an average particle diameter of 3 µm, 1.9 parts by weight of an acrylic binder, 3.7 parts by weight of α-terpineol solvent, and 0.2 part by weight of a dispersant.
(4) This conductor containing paste A was printed on the surface of the green sheet by screen printing, to form a printed layer for a guard electrode and a printed layer for a ground electrode in a lattice form (reference to Figs. 9 and 11).
   Moreover, the conductor containing paste B was filled into the through holes for the conductor-filled through holes for connecting the external terminals.
   The green sheets on which the conductor containing paste was printed and the green sheets on which no conductor containing paste was printed were laminated to each other, the number of the green sheets being 50. The green sheets were integrated with each other at 130 °C and a pressure of 8 MPa.
(5) Next, the lamination resulting from the integration was degreased at 600 °C for 5 hours and was then hot-pressed at 1890 °C and a pressure of 15 MPa for 3 hours to obtain an aluminum nitride plate-shaped body of 3 mm in thickness. This plate-shaped body was cut into a disk of 230 mm in diameter to prepare a ceramic substrate. About the size of the conductor-filled through holes, their diameter were 0.2 mm and their depth were 0.2 mm. The thickness of the guard electrode 5 and the ground electrode 6 was 10 µm. The position in the thickness direction of the sintered body where the guard electrode 5 was formed was 1 mm from the chucking face while the position in the thickness direction of the sintered body where the ground electrode 6 was formed was 1.2 mm from the resistance heating elements.
(6) The ceramic substrate obtained in the (5) was ground with a diamond grindstone. Subsequently a mask was put thereon, and bottomed holes to which thermocouples would be fitted and grooves 7 for adsorbing a wafer (width: 0.5 mm, depth: 0.5 mm) were made in the surface and a U figure-shaped notch (width: 2.5 mm, depth: 5 mm) was made at the circumferential rim portion by blast treatment with SiC and the like.
(7) Furthermore, a conductor containing paste was printed on the back face (bottom face) opposite to the chucking face in which the grooves 7 were made, so as to form a conductor containing paste layer for the resistance heating elements. The used conductor containing paste was Solvest PS603D made of Tokuriki Kagaku Kenkyu-zyo, which is used to form plated through holes in printed circuit boards. That is, this paste was a silver/lead paste, and contained metal oxides comprising lead oxide, zinc oxide, silica, boron oxide and alumina (the weight ratio thereof was 5/55/10/25/5). The amount of the oxides was 7.5% by weight of the amount of silver.
   The shape of the silver in the conductor containing paste was scaly and had an average particle diameter of 4.5 µm.
(8) The ceramic substrate on which the conductor containing paste was printed to form circuits (the ceramic substrate) was heated and fired at 780 °C to sinter silver and lead in the conductor containing paste and further bake them onto the ceramic substrate. In this way, the resistance heating elements were formed. The pattern of the resistance heating elements was made to the same pattern as in Example 1, which was a pattern of concentric circles-like combined with bending lines (reference to Fig. 1). Next, this ceramic substrate was immersed in an electroless nickel plating bath comprising an aqueous solution containing 30 g/L of nickel sulfate, 30 g/L of boric acid, 30 g/L of ammonium chloride, and 60 g/L of a Rochelle salt, to precipitate a nickel layer having a thickness of 1 µm and a boron content of 1 % or less by weight on the surface of the resistance heating elements made of the above-mentioned conductor containing paste. In this way, the thickness of the resistance heating elements was made larger. Thereafter, the ceramic substrate was annealed at 120 °C for 3 hours.
   The resistance heating elements 41 containing the thus obtained nickel layer had a thickness of 5 µm, a width of 2.4 mm and an area resistivity of 7.7 mΩ/□.
(9) Respective layers of Ti, Mo and Ni were successively deposited on the chucking face in which the grooves 7 were made by sputtering. Using SV-4540 made by ULVAC Japan Ltd. as a machine, the sputtering was performed under the following conditions: air pressure: 0.6 Pa, temperature: 100°C, electric power: 200 W, and processing times; 30 second to 1 minute. The sputtering times were adjusted dependently on the respective metals.
   About the resultant film, the thickness of Ti was 0.3 µm, that of Mo was 2 µm, and that of Ni was 1 µm from an image obtained by an X-ray fluorescence analyzer.
(10) The ceramic substrate obtained in the (9) was immersed in an electroless nickel plating bath comprising an aqueous solution containing 30 g/L of nickel sulfate, 30 g/L of boric acid, 30 g/L of ammonium chloride, and 60 g/L of a Rochelle salt, to precipitate a nickel layer (thickness: 7 µm) having a boron content of 1% or less by weight on the surface of the grooves 7 made in the chucking face. The nickel layer was heat-treated at 120 °C for 3 hours.
   Furthermore, the surface (the side of the chucking face) of the ceramic substrate was immersed in an electroless nickel plating solution comprising 2 g/L of potassium gold cyanide, 75 g/L of ammonium chloride, 50 g/L of sodium citrate, and 10 g/L of sodium hypophosphite at 93 °C for 1 minute, to deposit a gold plating layer 1 µm in thickness on the nickel layer at the chucking face side of the ceramic substrate. In this way, a chuck top conductor layer 2 was formed.
(11) Next, Air suction holes 8 reaching the back surface from the grooves 7 were made by drilling, and then blind holes for exposing the conductor-filled through holes 46 and 47 were formed. Brazing gold made of a Ni-Au alloy (Au: 81.5 wt%, Ni: 18.4 wt%, and impurities: 0.1 wt%) was used, and heated and reflowed at 970 °C to connect external terminals made of koval to the blind holes. External terminals made of koval were formed on the resistance heating elements 41 with a solder alloy (tin 9/lead 1) .
(12) In order to control the temperature, thermocouples were embedded in the bottomed holes, (not illustrated) , thus finishing the production of the heater having the wafer prober.

### (Comparative Example 1)

A ceramic heater was produced in the same way as in Example 1 except that no notch was formed and a through hole (diameter: 10 mm) was formed in the similar position instead(reference to Fig. 13). The distance from the side face of the ceramic substrate to the portion of the inner wall of the through hole, which is nearest to the side face was 5 mm.

The ceramic heaters and the wafer prober produced in Examples 1 and 3 and Comparative Example 1 were put on supporting cases having the structure illustrated in Fig. 5 which were made of stainless steel, through a heat insulating member made of polyimide, and then bolts (fixing members) made of stainless steel were passed through the notches and through holes in the heat insulating member. Furthermore, the bolts were screwed into threaded holes in the supporting cases to fix the ceramic heaters and the wafer prober to the supporting cases. About the electrostatic chuck of Example 2, its ceramic substrate was fitted into a supporting case and then a rotation-blocking pin was inserted into its through holes as illustrated in Fig. 4, so as to fix the electrostatic chuck.

Electric currents were sent to the ceramic heaters and so on of Examples 1 to 3 and Comparative Example 1 to heat them to 300 °C, the temperature was kept for 1 hour and then they were cooled. This step was repeated 100 times. Thereafter, the respective ceramic substrates were taken off from the supporting cases to observe whether a crack was generated or not.

As a result, in the ceramic substrates according to Examples 1 to 3 no crack was observed, but in the ceramic substrate according to Comparative Example 1 a crack was generated from the through holes formed near the circumferential rim portion of the ceramic substrate to the side face.

### Industrial Applicability

Since the ceramic substrate according to the present invention has a structure described above, no crack is generated by a shock and the like when the ceramic substrate is fitted to a supporting case or taken off therefrom. Moreover, no crack is generated by a thermal stress or a thermal shock generated inside when the ceramic substrate is heated after the fixation thereof to the supporting case. Additionally, the ceramic substrate can be taken off even if a fixing member is not completely pulled out; therefore, the ceramic substrate can be fitted or taken out in a short time. Furthermore, the ceramic substrate can be prevented from rotating; therefore, it is possible to prevent wirings connected to the ceramic substrate, and so on from being twisted or dropping out.

## Claims

1. A ceramic substrate having a conductor layer formed inside thereof or on the surface thereof,
wherein a notch is formed.

2. The ceramic substrate according to claim 1,
which has a resistance heating element formed inside thereof or on the surface thereof; and functions as a hot plate.

3. The ceramic substrate according to claim 1,
which has an electrostatic electrode formed inside thereof; and functions as an electrostatic chuck.

4. The ceramic substrate according to claim 1,
which has a chuck top conductor layer formed on the surface thereof; has a guard electrode and/or a ground electrode formed inside thereof; and functions as a wafer prober.
